Europäisches Patentamt

European Patent Office

Office européen des brevets

(11) Veröffentlichungsnummer : **0 170 813**
**B1**

# (12) EUROPÄISCHE PATENTSCHRIFT

(45) Veröffentlichungstag der Patentschrift :
07.09.88

(21) Anmeldenummer : 85106776.9

(22) Anmeldetag : 01.06.85

(51) Int. Cl.⁴ : **G 01 R 15/08**

(54) **Bereichsfortschalter für Messgeräte.**

(30) Priorität : 19.07.84 DE 3426617

(43) Veröffentlichungstag der Anmeldung :
12.02.86 Patentblatt 86/07

(45) Bekanntmachung des Hinweises auf die Patenterteilung : 07.09.88 Patentblatt 88/36

(84) Benannte Vertragsstaaten :
DE FR GB

(56) Entgegenhaltungen :
FR-A- 2 369 569
US-A- 4 105 967
ELECTRONIQUE ET APPLICATION INDUSTRIELLE,
Nr. 255, Juni 1978, Seite 16, Paris, FR; J. BRIAUD:
"Changement de gamme automatique"

(73) Patentinhaber : GRUNDIG E.M.V. Elektro-Mechanische Versuchsanstalt Max Grundig holländ. Stiftung &
Co. KG.
Kurgartenstrasse 37
D-8510 Fürth/Bay. (DE)

(72) Erfinder : Zwanzger, Hans, Dipl.-Ing. (FH)
Talblick 19a
D-8520 Erlangen (DE)

## Beschreibung

Die Erfindung bezieht sich auf einen Bereichsfortschalter für Meßgeräte, mit manueller und automatischer Bereichswahl.

Bekannte Meßgeräte mit Bereichsautomatiken weisen meist Bedienungselemente auf, die es erlauben, die Automatik abzuschalten und den gewünschten Meßbereich manuell einzustellen. Die manuelle Bereichsfortschaltung geschieht dabei in der Regel über je eine Fortschalttaste zum Weiterschalten in höhere Bereiche (UP) oder zum Schalten in niedrigere Bereiche (DOWN). Ein weiterer Schalter erlaubt bei diesen Meßgeräten die Umschaltung zwischen manueller und automatischer Bereichswahl. Ein Nachteil dieser Art umzuschalten ist die wenig ergonomische manuelle Bereichswahl, was sich insbesondere bei sehr vielen vorhandenen und anzuwählenden Bereichen als störend auswirkt. Auch bleibt nach dem Ausschalten des Meßgeräts der zuletzt eingestellte Bereich nicht erhalten.

Der Erfindung liegt die Aufgabe zugrunde, die Nachteile bekannter Bereichsfortschaltungen zu vermeiden und insbesondere eine ergonomisch sinnvolle Art der Bereichsfortschaltung bei gleichzeitiger Vereinfachung der zugehörigen Schaltung zu bewirken.

Diese Aufgabe wird erfindungsgemäß durch die im Patentanspruch 1 angegebenen Merkmale gelöst.

Vorteilhafte Weiterbildungen des erfindungsgemäßen Bereichsfortschalters ergeben sich aus den abhängiger Ansprüchen.

Mit dem erfindungsgemäßen Bereichsfortschalter wird eine leichte Bedienbarkeit des Meßgeräts erreicht, da ein Potentiometer und eine einfache zugehörige Schaltung vorgesehen sind. Je nach Drehwinkel und Auflösung des Potentiometers sind beliebig viele Bereiche realisierbar. Darüber hinaus genügt für den verwendeten Bereichszähler ein einfacher Vorwärtszähler. Auch läßt sich durch einfache Einstellung mit dem Potentiometer, beispielsweise an einem seiner Endanschläge, auf einfache Art und Weise die Bereichsautomatik des Meßgeräts aktivieren.

Die Erfindung wird im folgenden unter Bezugnahme auf die Zeichnungsfiguren beispielsweise näher erläutert. Es zeigen :

Fig. 1 ein schematisches Blockschaltbild zur Erläuterung des Prinzips des erfindungsgemäßen Bereichsfortschalters und

Fig. 2 ein ausführlicheres Schaltbild des erfindungsgemäßen Bereichsfortschalters gemäß Fig. 1.

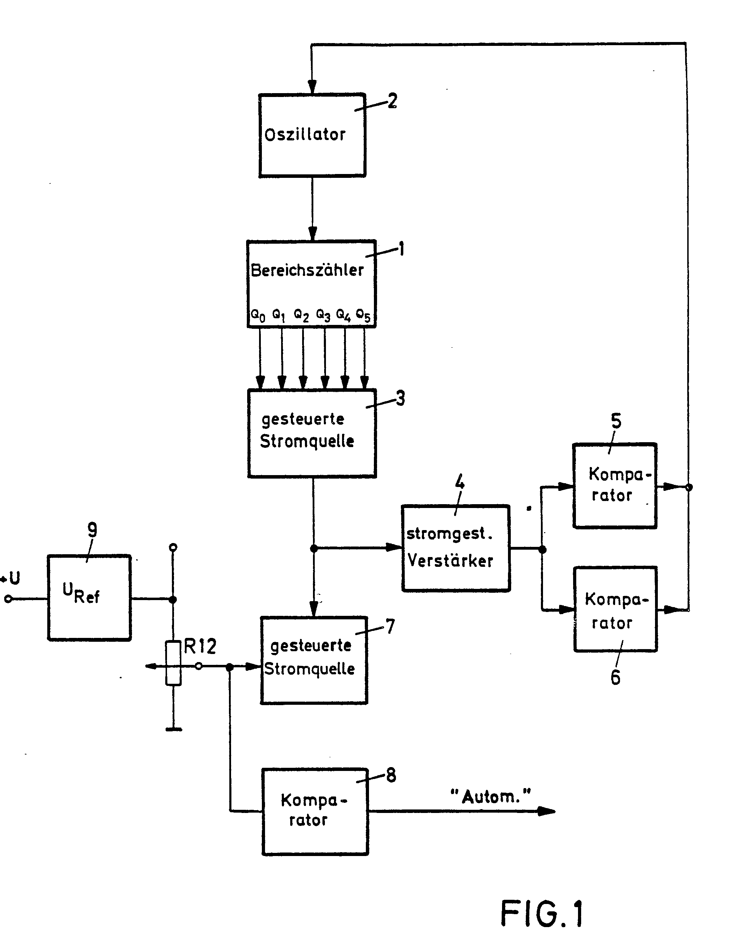

Gemäß Figur 1 ist ein von einem Oszillator 2 angesteuerter Bereichszähler 1, der beispielsweise ein 1 aus n-Zähler in CMOS-Technologie sein kann, mit seinen Ausgängen $Q_0$ bis $Q_5$ mit einer ersten gesteuerten Stromquelle 3 verbunden, die ihrerseits mit einem stromgesteuerten Verstärker 4 und einer zweiten gesteuerten Stromquelle 7 verbunden ist. Der Ausgang des stromgesteuerten Verstärkers 4 ist jeweils an den Eingang zweier Komparatoren 5 und 6 angeschlossen, deren Ausgänge mit dem Eingang des Oszillators 2 verbunden sind. Am Eingang der zweiten gesteuerten Stromquelle 7 ist der Abgriff eines Potentiometers R12 angeschlossen, das wiederum über eine Referenzspannungsquelle 9 mit dem Pluspol der Versorgungsspannung (+ U) verbunden ist. Zwischen dem Abgriff des Potentiometers R12 und dem Eingang der zweiten gesteuerten Stromquelle 7 ist ein dritter Komparator 8 angeschlossen, der bei beispielsweise an seinem einen Endanschlag befindlichem Potentiometer R12 ein Signal zur Aktivierung der Bereichsautomatik des Meßgeräts abgibt und eine Anzeigeeinheit für diese Funktion, z. B. eine Leuchtdiode, ansteuert.

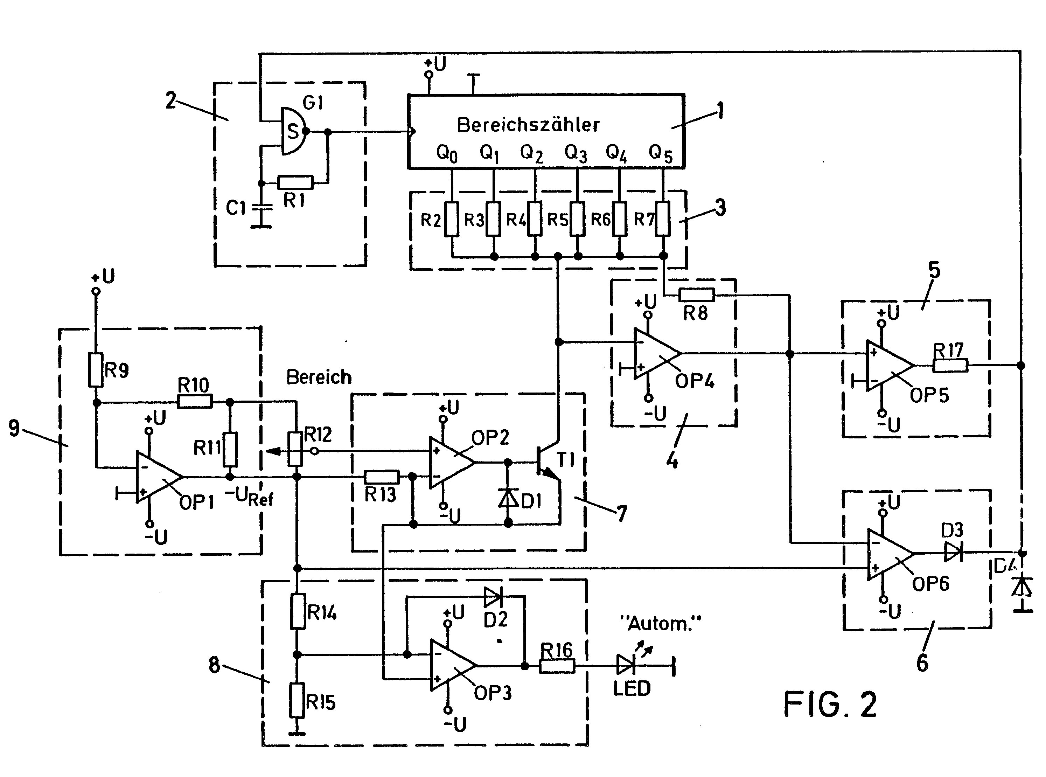

In Figur 2 sind die Schaltungsteile des erfindungsgemäßen Bereichsfortschalters nach Figur 1 ausführlicher dargestellt. So sind dort die Ausgänge $Q_0$ bis $Q_5$ des Bereichszählers 1 über die gesteuerte Stromquelle 3 darstellende Widerstände R2 bis R7 mit dem invertierenden Eingang eines Operationsverstärkers OP4 verbunden, der im wesentlichen den stromgesteuerten Verstärker 4 nach Figur 1 darstellt und dessen Ausgang über einen Widerstand R8 an seinen invertierenden Eingang rückgekoppelt ist. Der Ausgang des Operationsverstärkers OP4 ist ferner an den nichtinvertierenden Eingang eines Operationsverstärkers OP5 bzw. den invertierenden Eingang eines weiteren Operationsverstärkers OP6 geführt, die im wesentlichen die Komparatoren 5 und 6 gemäß Figur 1 bilden. Der invertierende Eingang des Operationsverstärkers OP5 ist mit Masse verbunden, während der nichtinvertierende Eingang des Operationsverstärkers OP6 mit dem einen Anschluß des Potentiometers R12 verbunden ist. Über einen Widerstand R17 bzw. eine Diode D3 ist der Ausgang des Operationsverstärkers OP5 bzw. OP6 mit dem Eingang des Oszillators 2 verbunden, der im Ausführungsbeispiel nach Figur 2 aus einem astabilen Multivibrator G1 mit Widerstand R1 und Kondensator C1 besteht.

Gemäß Figur 2 ist ferner der Pluspol + U der Versorgungsspannung über einen Widerstand R9 mit dem invertierenden Eingang eines Operationsverstärkers OP1 verbunden, dessen nichtinvertierender Eingang an Masse liegt. Der Ausgang des Operationsverstärkers OP1 ist über einen Widerstand R11 und einen Widerstand R10 an den invertierenden Eingang des Operationsverstärkers OP1 rückgekoppelt und ferner mit dem einen Anschluß des Potentiometers R12, der auch mit dem nichtinvertierenden Eingang des Operationsverstärkers OP6 verbunden ist, verschaltet. Der andere Anschluß des Potentiometers R12 ist an die Verbindung der Widerstände R10 und R11 angeschlossen.

Der Ausgang des Operationsverstärkers OP1 ist ferner über einen Widerstand R13 mit dem invertierenden Eingang eines Operationsverstärkers OP2 verbunden, der zusammen mit einer ausgangsseitig angeschlossenen Diode D1 und einem Transistor T1 die zweite gesteuerte Stromquelle 7 gemäß Fig. 1 bildet. Dabei ist der Ausgang des Operationsverstärkers OP2 mit der Kathode der Diode D1 und der Basis des Transistors T1 verbunden, während die Anode der Diode D1 und der Emitter des Transistors T1 an den invertierenden Eingang des Operationsverstärkers OP2 rückgeführt sind. Der nichtinvertierende Eingang des Operationsverstärkers OP2 ist mit dem Abgriff des Potentiometers R12 verbunden. Der Kollektor des Transistors T1 ist mit dem invertierenden Eingang des Operationsverstärkers OP4 verbunden.

Der Ausgang des Operationsverstärkers OP1 ist ferner über einen Spannungsteiler R14 und R15 mit dem invertierenden Eingang eines Operationsverstärkers OP3 verbunden, der im wesentlichen den Komparator 8 gemäß Fig. 1 bildet. Der nichtinvertierende Eingang des Operationsverstärkers OP3 ist mit dem invertierenden Eingang des Operationsverstärkers OP2 verbunden, während in die Verbindung zwischen Ausgang und invertierendem Eingang des Operationsverstärkers OP3 eine Diode D2 geschaltet ist. Der Ausgang des Operationsverstärkers OP3 ist ferner über einen Widerstand R16 an eine Leuchtdiode LED geführt, die die Aktivierung der Bereichsautomatik des Meßgeräts durch ein Signal am Ausgang des Operationsverstärkers OP3 anzeigt.

Die Funktion der vorstehend beschriebenen erfindungsgemäßen Schaltung nach Figur 2 wird nun im folgenden näher erläutert:

Bei H-Pegel (logische « 1 ») am Ausgang $Q_0$ des Bereichszählers 1 fließt über den Widerstand R2 ein Strom von beispielsweise 10 μA, während bei H-Pegel an den anderen Ausgängen $Q_1$ bis $Q_5$ über die Widerstände R3 bis R7 ein jeweils um beispielsweise 10 μA höherer Strom fließt.

Der Operationsverstärker OP1 erzeugt an seinem Ausgang eine negative Referenzspannung $-U_{Ref}$, deren Größe sich proportional zur positiven Betriebsspannung + U und damit zum Strom über die Widerstände R2 bis R7 verhält, wobei R11 = 5 R10 und R12 ≫ R11 ist.

Am Abgriff des Potentiometers R12 steht demnach eine Spannung zwischen $-U_{Ref}$ und $U_{Ref}/6$ an.

Der Widerstand R13 am invertierenden Eingang des Operationsverstärkers OP2 der gesteuerten Stromquelle 7 läßt dabei über den Transistor T1 einen Korrekturstrom von 0 ... 60 μA fließen

$$\left( R13 = \frac{|U_{Ref}|}{60 \ \mu A} \right).$$

Der invertierende Eingang des Operationsverstärkers OP4 des stromgesteuerten Verstärkers 4 bildet einen Summationspunkt für den vom Transistor T1 her fließenden Referenzstrom und dem bereichstypischen Strom der Widerstände R2 bis R7. Ist der absolute Wert des Referenzstroms um mehr als 12 μA kleiner als der Zählerstrom des Bereichszählers 1, so steht am Ausgang des Operationsverstärkers OP4 die negative Referenzspannung $-U_{Ref}$ an, d. h. der Widerstand R8 hat den Wert

$$R8 = \frac{|U_{Ref}|}{12 \ \mu A}.$$

Der Operationsverstärker OP6 stellt für die negative Referenzspannung $-U_{Ref}$ einen Schwellwertschalter dar, während der Operationsverstärker OP5 einen Schwellwertschalter für 0 Volt darstellt.

Ist der vom Transistor T1 her fließende Referenzstrom kleiner als der Zählerstrom von $-12$ μA oder größer als der Zählerstrom, so erhält der Bereichszähler 1 Fortschaltimpulse aus dem astabilen Multivibrator G1, und zwar solange, bis sich am Ausgang des am invertierenden Eingang mit zwei Strömen beaufschlagten Operationsverstärkers OP4 eine Spannung einstellt, die innerhalb des Schwellenfensters liegt. Der Bereichszähler 1 hat dann den gewünschten Ausgangszustand. Die beiden Ströme am invertierenden Eingang des Operationsverstärkers 4 sind dabei zum einen abhängig von der positiven Versorgungsspannung, bestimmt vom Stand des Bereichszählers 1, der in jedem Bereich einen bekannten und aufgrund der Widerstände R2 bis R7 abgestuften Strom an den Operationsverstärker OP4 abgibt, zum anderen abhängig von einem Strom von « — » her, dessen Größe vom Potentiometer R12 für die einzelnen Bereiche bestimmt wird und der gleichzeitig an den invertierenden Eingang gelegt ist. Sind beide Ströme nicht gleich, so geht der Ausgang des Operationsverstärkers OP4 nach « + » oder « — » und über- oder unterschreitet am Operationsverstärker OP5 oder 6 den Schwellwert des jeweiligen Operationsverstärkers und führt dazu, daß am Ausgang des Operationsverstärkers und führt dazu, daß am Ausgang des Operationsverstärkers OP5 bzw. OP6 H-Pegel ansteht. Dieses Potential wird auf den Start-Stop-Eingang des astabilen Multivibrators G1 gegeben, worauf dieser anläuft und der Bereichszähler 1 startet, der seinerseits nur hoch, und nicht vor-/ rückwärts zählt. Der Bereichszähler 1 zählt solange, bis der Strom aus den Ausgängen am Summationspunkt des Operationsverstärkers OP4 gleich ist mit dem Wert am Potentiometer R12.

Die Ausgänge der Operationsverstärker OP5 und OP6 sind auf Null, wenn die Summe der beiden Ströme Null ist ; das bedeutet, daß der durch das Potentiometer R12 eingestellte Bereich stabil eingestellt ist. Das Schwellen(Zeit)fenster der Operationsverstärker OP5 und 6 (z. B. zwischen 0 und $-5$ V) ist nötig, damit eine Schalthysterese gewährleistet ist. D. h. das Schwellenfenster bewirkt zusammen mit dem Widerstand R8 am Operationsverstärker OP4 eine Bereichshysterese (großer Bereich des Potentiometers R12), innerhalb der Bereichszähler noch nicht weiterschaltet.

Da der Widerstand R9 an der selben Versorgungsspannung (+ U) hängt wie der Bereichszähler 1, ändert sich die Spannung am Widerstand R11 oder Potentiometer R12 und der Strom durch den Transistor T1 am Summationspunkt (invertierender Eingang des Operationsverstärkers OP4) ist proportional zum Wert des Bereichszählers 1. Das heißt, die negative Referenzspannung —$U_{Ref}$ ändert sich im selben Ausmaß wie die positive Versorgungsspannung + U, an der der Bereichszähler 1 und die erste gesteuerte Stromquelle 3 hängen.

Wie bereits weiter vorne ausgeführt, ist der Komparator 8 mit dem Operationsverstärker OP3 und dem Spannungsteiler (R14) und R15 in Verbindung mit dem Potentiometer R12 für die Aktivierung der Bereichsautomatik des Meßgeräts vorgesehen. Liegt nämlich beispielsweise der Schleifer des Potentiometers R12 an einem (z. B. dem linken) Anschlag, so hat der Ausgang des Operationsverstärkers OP3 H-Pegel, wobei die Spannungsteilerwiderstände R14, R15 hierfür entsprechend bemessen sind. Dieses Ausgangssignal des Operationsverstärkers OP3 schaltet über den Widerstand R16 die Bereichsautomatik ein und dient gleichzeitig zur Ansteuerung einer optischen Anzeige, z. B. einer Leuchtdiode LED, die diese Betriebsfunktion anzeigt. Der Bereichszähler 1 hängt dann nicht mehr vom Potentiometer R12 ab.

## Patentansprüche

1. Bereichsfortschalter für Meßgeräte mit manueller und automatischer Bereichswahl, dadurch gekennzeichnet, daß ein über einen Oszillator (2) fortschaltbarer Bereichszähler (1) vorgesehen ist, an dessen Ausgängen ($Q_0$, $Q_1$, $Q_2$, $Q_3$, $Q_4$, $Q_5$) von dem jeweiligen Zählerstand abhängige « High »- und/oder « Low »-Pegel abgreifbar sind, die den Ausgangsstrom einer ersten Stromquelle (3) steuern, und daß der Ausgang der ersten Stromquelle (3) sowie der Ausgang einer manuell steuerbaren zweiten Stromquelle (7, 9, R12) mit dem Eingang eines stromgesteuerten Verstärkers (4) verbunden sind, der in Abhängigkeit von der Summe der Ausgangsströme der Stromquellen zwei parallel liegende, als Schwellwertschalter wirkende Komparatoren (5, 6) steuert, die den zur Fortschaltung des Bereichszählers (1) vorgesehenen Oszillator (2) ein- und ausschalten.

2. Bereichsfortschalter nach Anspruch 1, dadurch gekennzeichnet, daß die manuell steuerbare zweite Stromquelle (7, 9, R12) zur Einstellung der Bereiche ein Potentiometer (R12) enthält, über das eine zur zweiten Stromquelle gehörende Referenzspannung (9) teilbar ist.

3. Bereichsfortschalter nach Anspruch 1 oder 2, dadurch gekennzeichnet, daß der Bereichszähler (1) als Vorwärtszähler ausgebildet ist.

4. Bereichsfortschalter nach einem der Ansprüche 1 bis 3, dadurch gekennzeichnet, daß die erste Stromquelle (3) als summierendes Widerstandsnetzwerk (R2 bis R7) ausgebildet ist, das von den an den Ausgängen ($Q_0$, $Q_1$, $Q_2$, $Q_3$, $Q_4$,

$Q_5$) des Bereichszählers (1) stehenden « High »- und/oder « Low »-Pegeln angesteuert wird.

5. Bereichsfortschalter nach einem der Ansprüche 1 bis 4, dadurch gekennzeichnet, daß die am Potentiometer (R12) abgreifbare geteilte Referenzspannung dem Eingang eines weiteren als Schwellwertschalter wirkenden Komparators (8) zugeführt ist, der nach Überschreiten eines bestimmten Schwellwertes die manuelle Bereichswahl abschaltet und eine geeignete Bereichsautomatik aktiviert.

6. Bereichsfortschalter nach einem der vorhergehenden Ansprüche 1 bis 5, dadurch gekennzeichnet, daß für die Komparatoren (5, 6, 8), den stromgesteuerten Verstärker (4) und die zweite gesteuerte Stromquelle (7) Operationsverstärker (OP5, OP6, OP3 ; OP4 ; OP2) vorgesehen sind.

7. Bereichsfortschalter nach einem der vorhergehenden Ansprüche 4 bis 6, dadurch gekennzeichnet, daß zur Erzielung genauer Drehwinkelwerte das Potentiometer (R12) über einen weiteren Operationsverstärker (OP1) angesteuert wird, der an seinem Ausgang eine sich proportional zur positiven Betriebsspannung und dem Strom über das summierende Widerstandsnetzwerk (R2 bis R7) größenmäßig ändernde negative Referenzspannung (—$U_{Ref}$) abgibt.

## Claims

1. Range stepping switch for measuring instruments having manual and automatic range selection, characterized in that a range counter (1) is provided which can be stepped via an oscillator (2) and at the outputs ($Q_0$, $Q_1$, $Q_2$, $Q_3$, $Q_4$, $Q_5$) of which « high » and/or « low » levels dependent on the respective counter reading can be picked up which control the output current of a first current source (3), and that the output of the first current source (3) and the output of a manually controllable second current source (7, 9, R12) are connected to the input of a current-controlled amplifier (4) which controls, in dependence on the sum of the output currents of the current sources, two parallel-connected comparators (5, 6) acting as threshold switches and which switch on and off the oscillator (2) provided for stepping the range counter (1).

2. Range stepping switch according to Claim 1, characterized in that, for setting the ranges, the manually controllable second current source (7, 9, R12) contains a potentiometer (R12) via which a reference voltage (9) belonging to the second current source can be divided.

3. Range stepping switch according to Claim 1 or 2, characterized in that the range counter (1) is constructed as an up counter.

4. Range stepping switch according to one of Claims 1 to 3, characterized in that the first current source (3) is constructed as summing resistance network (R2 to R7) which is driven by the « high » and/or « low » levels present at the outputs ($Q_0$, $Q_1$, $Q_2$, $Q_3$, $Q_4$, $Q_5$) of the range counter (1).

5. Range stepping switch according to one of Claims 1 to 4, characterized in that the divided reference voltage which can be picked up at the potentiometer (R12) is supplied to the input of another comparator (8) acting as threshold switch which switches off the manual range selection and activates a suitable automatic range selection system after a particular threshold has been exceeded.

6. Range stepping switch according to one of the preceding Claims 1 to 5, characterized in that operational amplifiers (OP5, OP6, OP3 ; OP4 ; OP2) are provided for the comparators (5, 6, 8), the current-controlled amplifier (4) and the second controlled current source (7).

7. Range stepping switch according to one of the preceding Claims 4 to 6, characterized in that, to achieve accurate values of angle of rotation, the potentiometer (R12) is driven via another operational amplifier (OP1) which emits at its output a negative reference voltage ($- U_{ref}$), the magnitude of which changes proportionally to the positive operating voltage and to the current through the summing resistance network (R2 to R7).

**Revendications**

1. Commutateur de gammes pour des appareils de mesure à sélection manuelle et automatique de gammes, caractérisé en ce qu'il est prévu un compteur de gammes (1), dont le comptage progressif peut s'effectuer par l'intermédiaire d'un oscillateur (2) et sur les sorties ($Q_0$, $Q_1$, $Q_2$, $Q_3$, $Q_4$, $Q_5$) duquel on peut prélever des niveaux « hauts » et/ou « bas », qui dépendent de l'état respectif de comptage et commandent le courant de sortie d'une première source de courant (3), que la sortie de la première source de courant (3) ainsi que la sortie d'une seconde source de courant (7, 9, R12) pouvant être commandée manuellement sont reliées à l'entrée d'un amplificateur (4) commandé par le courant et qui commande, en fonction de la somme des courants de sortie des sources de courant, deux comparateurs (5, 6), qui sont branchés en parallèle, agissent en tant que commutateurs à valeurs de seuil et branchent et débranchent l'oscillateur (2) prévu pour la mise en œuvre du comptage progressif du compteur de gammes (1).

2. Commutateur de gammes selon la revendication 1, caractérisé en ce que la seconde source de courant (7, 9, R12), qui peut être commandé manuellement et sert à régler les gammes, contient un potentiomètre (R12), au moyen duquel une tension de référence (9) associée à la seconde source de courant, peut être divisée.

3. Commutateur de gammes selon la revendication 1 ou 2, caractérisé en ce que le compteur de gammes (1) est réalisé sous la forme d'un compteur progressif.

4. Commutateur de gammes selon l'une des revendications 1 à 3, caractérisé en ce que la première source de courant (3) est réalisée sous la forme d'un réseau additionneur formé de résistances (R2 à R7) et commandé par les niveaux « hauts » et/ou « bas » qui sont présents sur les sorties ($Q_0$, $Q_1$, $Q_2$, $Q_3$, $Q_4$, $Q_5$) du compteur de gammes (1).

5. Commutateur de gammes selon l'une des revendications 1 à 4, caractérisé en ce que la tension de référence divisée, qui peut être prélevée sur le potentiomètre (R12), est envoyée à l'entrée d'un autre comparateur (8) agissant en tant que commutateur à valeur de seuil, qui, après le dépassement d'une valeur de seuil déterminée, débranche la sélection manuelle des gammes et active un dispositif automatique de sélection des gammes.

6. Commutateur de gammes selon l'une des revendications précédentes 1 à 5, caractérisé en ce que des amplificateurs opérationnels (OP5, OP6, OP3 ; OP4 ; OP2) sont prévus pour les comparateurs (5, 6, 8), pour l'amplificateur (4) commandé par le courant et pour la seconde source de courant commandée (7).

7. Commutateur de gammes selon l'une des revendications 4 à 6 précédentes, caractérisé en ce que, pour l'obtention de valeurs précises d'angles de rotation, le potentiomètre (R12) est commandé par l'intermédiaire d'un autre amplificateur opérationnel (OP1), qui délivre, sur sa sortie, une tension de référence négative ($- U_{Ref}$) dont la valeur varie proportionnellement à la tension de service positive et au courant circulant dans le circuit additionneur formé de résistances (R2 à R7).

FIG.1

FIG. 2